# EUROPEAN PATENT SPECIFICATION

(11) **EP 0 303 975 B1**
(45) Date of publication and mention of the grant of the patent: **19.07.1995**
(21) Application number: 88113079.3
(22) Date of filing: 11.08.1988
(51) Int. Cl.: H01R 9/09, H05K 3/36

(54) **An arrangement for connecting a hybrid circuit to a mother board**
Vorrichtung zum Verbinden einer Hybridschaltung mit einer Grundplatine
Dispositif pour connecter un circuit hybride sur une carte mère

(30) Priority: 21.08.1987 FI 873620
(43) Date of publication of application: 22.02.1989
(73) Proprietor: NOKIA MOBILE PHONES LTD., 24101 Salo (FI)
(72) Inventor: Väisänen, Risto, SF-24100 Salo (FI)
(74) Representative: Frain, Timothy John

(56) References cited:
- EP-A- 0 089 452
- FR-A- 2 442 570
- FR-A- 2 503 977
- US-A- 4 109 298
- PATENT ABSTRACTS OF JAPAN, vol. 9, no. 61 (E-303)(1784), 19 March 1985; & JP-A-59 198742

## Description

The present invention relates to an arrangement for connecting a hybrid circuit to a mother board, the hybrid circuit comprising a printed circuit board with foils on both sides, components fixed to the printed circuit board, and printed circuit board legs by means of which the printed hybrid circuit board is connected to the mother board the legs of the printed circuit board consisting of projections in the board itself and the mother board having apertures corresponding to the legs.

Such an arrangement is known from JP-A- 59 198 742.

It is previously known to fix to a printed hybrid circuit board various legs made of a well conductive material, which are connected to the components in the hybrid circuit via conductor strips of the printed circuit board and mate with apertures correspondingly made in the mother board. Such legs may be separate, or they may consist of one mechanical entity which has at predetermined intervals contact pins and is mechanically fixed to the edge of the printed circuit board. Such a structure tends to be mechanically weak, or it is space-consuming and costly if it is made sturdy enough. It is also not optimal in terms of freedom from interference, since the joints between the conductor foils and the legs form electric discontinuity points.

The object of the present invention as claimed in claim 1 is to provide between a hybrid circuit and a mother board a connection which is maximally easy to manufacture, sturdy, and electrically interference-free. To achieve this, the invention is characterized in that the apertures being insulating, the earth foils and conductor foils in the projections being connected to the foils of the mother board at the edges of the apertures.

The projections are preferably formed in the edge of the printed circuit board by grinding and/or drilling, whereby the roots of the legs will be rounded. In a corresponding manner the apertures in the mother board are also made oval and rounded in such a way that two opposite parallel sides are straight over the distance of the width of the leg. The connecting of the leg of the printed circuit board to the mother board is then effected by soldering along these straight parts. Most suitably each projection has on one side an earth foil and on the other side at least one conductor foil.

The invention is described below in greater detail in the form of an example and with reference to the accompanying drawings, in which
Figure 1 depicts a diagrammatic side view of the printed circuit board itself,
Figure 2 depicts a perspective representation of the entire hybrid circuit with its RF-shielding cover,
Figures 3 and 4 depict the shielding cover 5, as seen from the side, respectively as seen from the end and sectioned, and
Figures 5 and 6 depict on a larger scale how the legs of the printed circuit board engage in the mother board.

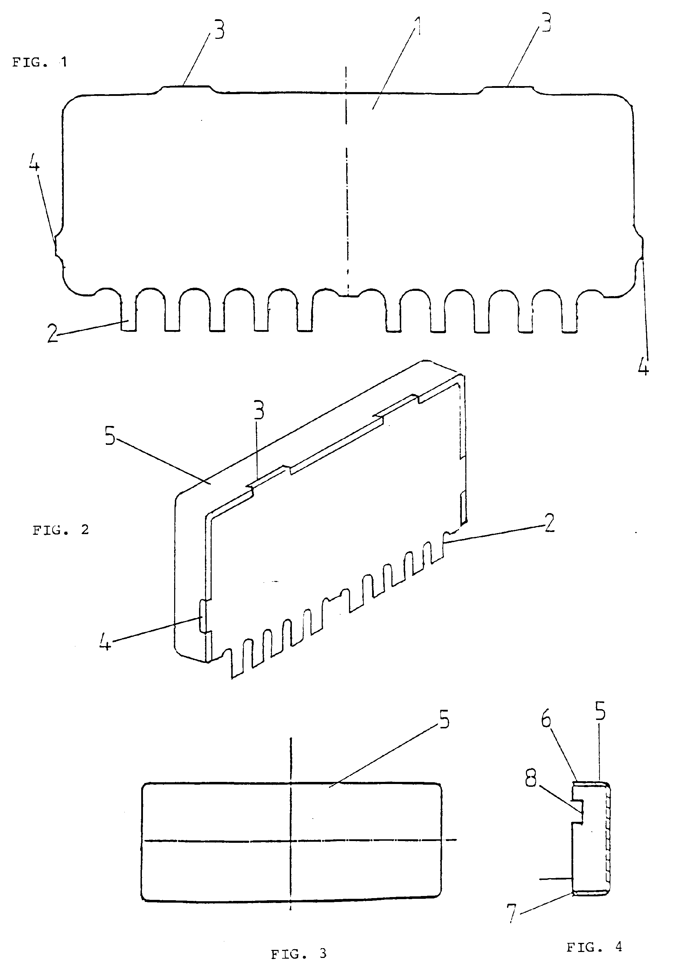

Figure 1 thus shows diagrammatically a printed circuit board 1, which is of an insulation material and has on one side an earth foil and on the other side conductor foils, as will be described below. Furthermore, all the components of the circuit, not shown here, are fixed to the printed circuit board 1.

Figure 2 depicts the entire hybrid circuit, which consists of the printed circuit board 1 with its components and legs 2, and of a cover, connected to it, which has been pressed from a metal sheet and been attached by its edges to the printed circuit board 1 by, for example, soldering to its earth foil.

Figures 3 and 4 further depict only the metal cover 5, as seen directly from the side of the cover and as seen from the end and sectioned. In the edge of the cover 5 there are two notches 7 for receiving protrusions 3 of the printed circuit board 1 and two notches 8 for receiving protrusions 4. In addition, there is a deeper continuous or two-part notch 6 through which the legs 2 extend from the housing.

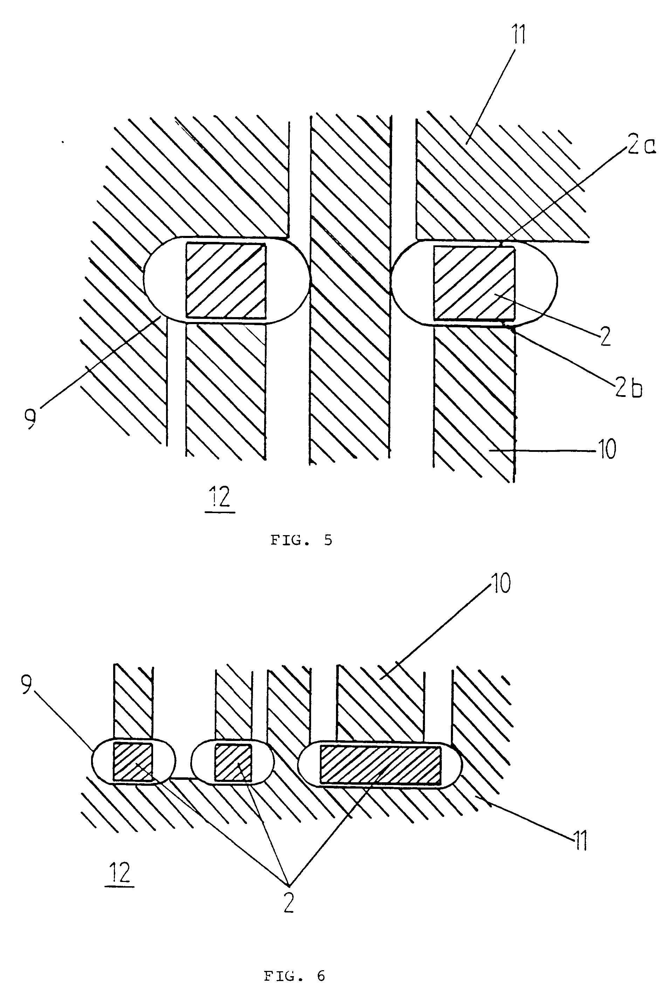

Figures 5 and 6 depict on a larger scale in detail how the legs 2 of the hybrid circuit are connected to the mother board. The legs may be of a square cross section, as in Figure 5, or at least some of them may be rectangular, as shown in Figure 6. In the mother board 12 there are corresponding apertures 9 in which the legs 2 fit so that those sides of the legs in which the earth foils and conductor foils 2a and 2b are located approximately coincide with the edges of the aperture 9. In terms of manufacture, it is easiest to make the apertures 9 by drilling and grinding so that their shape will be oval.

In the case presented, the foils of the mother board are located on one and the same side. The earth foil is indicated by reference numeral 11 and the conductor foil by reference numeral 10. The apertures 9 are not copper-plated throughout, and, when necessary, the earth foils and the conductor foils of the mother board may be situated on different sides of the mother board. It is also clear, especially if the leg 2 is especially broad, as shown on the right in Figure 6 , that there may be several conductor foils in the leg which respectively connect with several conductor foils in the mother board. The earth foils and conductor foils in the legs 2 of the printed circuit board are connected to the earth foils and conductor foils of the mother board 12 by soldering along the parallel opposite sides of the apertures 9.

## Claims

1. An arrangement for connecting a hybrid circuit to a mother board, the hybrid circuit comprising a printed circuit board (1) of an insulating material, with foils (2a, 2b) on both sides, components fixed to the printed circuit board, and printed circuit board legs (2) by means of which the hybrid printed circuit board is connected to the mother board (12), the legs of the printed circuit board consisting of projections (2) in the board (1) itself, and in the mother board (12) there are apertures (9) corresponding to the legs, **characterized in** that the apertures are insulating, the earth foils and conductor foils (2a, 2b) in the projections (2) being connected to the foils (10, 11) of the mother board (12) at the edges of the apertures (9).

2. A hybrid circuit according to Claim 1, **characterized in that** the projections (2) have been formed by grinding and/or drilling notches in the edge of the board (1).

3. A system according to Claim 2, **characterized in that** the inner edges of the notches are rounded.

4. A system according to Claim 1 or 2, **characterized in** that each projection (2) has at least on one side an earth foil (2a) and on the other side at least one conductor foil.

5. A system according to Claim 1, **characterized in that** the apertures (9) in the mother board (12) are oval, corresponding in their width to the thickness of the printed circuit board (1).

## Patentansprüche

1. Anordnung zum Verbinden einer Hybridschaltung mit einer Grundplatte, wobei die Hybridschaltung eine Leiterplatte (1) aus einem isolierenden Material mit Folien (2a, 2b) auf beiden Seiten, an der Leiterplatte befestigte Bauteile, sowie Leiterplattenfüße (2), mit denen die Hybridleiterplatte an der Grundplatte (12) befestigt wird, umfaßt, wobei die Füße der Leiterplatte aus Vorsprüngen (2) an der Platte (1) selbst bestehen, und in der Grundplatte (12) Öffnungen (9) vorhanden sind, die den Füßen entsprechen, **dadurch gekennzeichnet**, daß die Öffnungen isolierend sind, wobei die Erdfolien und die leitenden Folien (2a,2b) an den Vorsprüngen (2) mit den Folien (10,11), der Grundplatte (12) an den Rändern der Öffnungen (9) verbunden sind.

2. Hybridschaltung nach Anspruch 1, **dadurch gekennzeichnet,** daß die Vorsprünge (2) durch das Schleifen und/oder Bohren von Einkerbungen in den Rand der Platte (1) hergestellt wurden.

3. System nach Anspruch 2, **dadurch gekennzeichnet**, daß die Innenränder der Einkerbungen abgerundet sind.

4. System nach Anspruch 1 oder 2, **dadurch gekennzeichnet**, daß jeder Vorsprung (2) an wenigstens einer Seite eine Erdfolie (2a) und an der anderen Seite wenigstens eine Leiterfolie aufweist.

5. System nach Anspruch 1, **dadurch gekennzeichnet**, daß die Öffnungen (9) in der Grundplatte (12) oval sind und ihre Breite der Dicke der Leiterplatte (1) entspricht.

## Revendications

1. Assemblage pour connecter un circuit hybride à une platine principale, le circuit hybride comportant une plaque de circuit imprimé (1) en un matériau isolant, avec des feuilles (2a, 2b) métalliques des deux côtés, des composants fixés au circuit imprimé, et des plots (2) du circuit imprimé au moyen desquels le circuit imprimé hybride est connecté à la platine principale (12), les plots du circuit imprimé consistant en des languettes (2) de la plaque (1) elle-même, et la platine principale (12) comportant des ouvertures (9) correspondant aux plots, caractérisé en ce que les ouvertures sont isolantes, la feuille de mise à terre et la feuille conductrice (2a, 2b) à l'emplacement des languettes (2) étant connectées avec les feuilles (10, 11) de la platine principale (12) aux bords des ouvertures (9).

2. Circuit hybride selon la revendication 1, caractérisé en ce que les languettes (2) sont réalisées par meulage et/ou perçage d'encoches sur le bord du circuit (1).

3. Dispositif selon la revendication 2, caractérisé en ce que les arêtes intérieures des encoches sont arrondies.

4. Dispositif selon une des revendications 1 ou 2, caractérisé en ce que chaque languette (2) comporte une feuille de mise à terre (2a) sur au moins un côté et au moins une feuille conductrice de l'autre côté.

5. Dispositif selon la revendication 1, caractérisé en ce que les ouvertures (9) dans la platine principale (12) sont ovales et que leur largeur correspond à l'épaisseur de la plaque du circuit imprimé (1).
